# EUROPÄISCHE PATENTSCHRIFT

(11) **EP 1 155 602 B1**
(45) Veröffentlichungstag und Bekanntmachung des Hinweises auf die Patenterteilung: **06.08.2003**
(21) Anmeldenummer: 00910519.8
(22) Anmeldetag: 01.02.2000
(51) Int. Cl.: H05K 3/32, H05K 3/34

(54) **ELEKTRISCHES VERBINDUNGSVERFAHREN UND VERBINDUNGSSTELLE**
ELECTRICAL CONNECTION METHOD AND CONNECTION SITE
PROCEDE DE CONNEXION ELECTRIQUE ET SITE DE CONNEXION

(30) Priorität: 18.02.1999 DE 19906807
(43) Veröffentlichungstag der Anmeldung: 21.11.2001
(73) Patentinhaber: SIEMENS AKTIENGESELLSCHAFT, 80333 München (DE)
(72) Erfinder: LOIBL, Josef, D-94209 Regen (DE); HAUPT, Detlef, D-93128 Steinsberg (DE); FRANZEN, Frank, D-93049 Regensburg (DE)
(86) Internationale Anmeldenummer: DE0000308
(87) Internationale Veröffentlichungsnummer: WO00049841

(56) Entgegenhaltungen:
- EP-B- 0 163 581
- WO-A-98/44593
- DE-A- 19 618 099
- GB-A- 1 018 622
- US-A- 5 462 626
- US-A- 5 676 865
- PATENT ABSTRACTS OF JAPAN vol. 1996, no. 8, 30. August 1996 (1996-08-30) & JP 08 107272 A (CASIO COMPUT CO), 23. April 1996 (1996-04-23)
- PATENT ABSTRACTS OF JAPAN vol. 1995, no. 7, 31. August 1995 (1995-08-31) & JP 07 094035 A (SUMITOMO ELECTRIC IND ), 7. April 1995 (1995-04-07)
- 29602: "Heterocyclic organic metal complex surface in laser welding for surface mount interconnections" RESEARCH DISCLOSURE., Nr. 296, Dezember 1988 (1988-12), Seiten 937-2, XP000096875 INDUSTRIAL OPPORTUNITIES LTD. HAVANT., GB ISSN: 0374-4353

## Beschreibung

Die Erfindung betrifft ein Verfahren zur Herstellung einer elektrischen Verbindung zwischen einer flexiblen Leiterplatte und einem metallischen Kontaktpartner, eine zwischen den genannten Elementen realisierte elektrische Verbindungsstelle sowie eine Anordnung zum vollständigen Einbau in einen Motor oder ein Getriebe eines Kraftfahrzeugs (Kfz), die eine solche elektrische Verbindungsstelle nutzt.

Es sind bereits eine Vielzahl von Verbindungstechniken zum Verbinden von elektrischen Bauelementen mit einer flexiblen Leiterplatte bekannt.

In der Patentschrift US 5,676,865 ist ein Verfahren zur Realisierung einer Schweißverbindung zwischen einer flexiblen Leiterplatte und einem metallischen Leiter beschrieben. Bei diesem Verfahren werden zunächst gegenüberliegende Öffnungen in die boden- und deckenseitigen Isolationsschichten der flexiblen Leiterplatte eingebracht, so daß eine zwischenliegend verlaufende Leiterbahn in den Öffnungsbereichen beidseitig freiliegt. Die freiliegende Leiterbahn wird mit einem Zentralloch versehen. Nachfolgend wird der Lochrand der Leiterbahn so umgeformt, daß er mit dem elektrischen Leiter in Kontakt gelangt, auf dem die flexible Leiterplatte bodenseitig aufliegt. Zuletzt wird die Leiterbahn mittels eines Lasers im Lochbereich an den Leiter angeschweißt.

Ein Problem dieses Verfahrens besteht darin, daß aufgrund des Zentrallochs gelegentlich nicht ausreichend Leiterbahnmaterial für eine sichere und dauerhafte Schweißverbindung zur Verfügung steht. Ferner kann das definierte Herunterbiegen des Lochrands auf den Leiter technische Probleme bereiten.

Aus der Patentschrift EP 0 163 581 B1 ist eine durch eine gebogene, flexible, zweilagige Verbindungsleiterplatte gebildete elektrische Verbindung zwischen zwei parallelen Leiterplatten bekannt, die durch eine Wärmesenke getrennt sind. Die beiden parallelen Leiterplatten weisen jeweils vorspringende Kontaktstücke auf, die an eine freiliegende Kontaktstelle der Leiterplatte gelötet sind. Das Herstellen einer Schweißverbindung zwischen der flexiblen zweilagigen Leiterplatte und dem Kontaktstück ist nicht möglich.

Der Erfindung liegt die Aufgabe zugrunde, ein Verfahren zur Herstellung einer elektrischen Verbindung zwischen einer flexiblen Leiterplatte und einem metallischen Kontaktpartner anzugeben, das einfach und kostengünstig durchzuführen ist und gleichzeitig eine mechanisch stabile und elektrisch sichere Verbindung realisiert. Insbesondere sollen die mittels des Verfahrens geschaffenen Verbindungsstellen auch für eine Kontaktierung von elektrischen Bauteilen unter erschwerten Umgebungsbedingungen, wie sie in einem Getriebe oder Motor eines Kfz herrschen, geeignet sein.

Zur Lösung der Aufgabe sind die Merkmale der unabhängigen Ansprüche vorgesehen.

Da die Öffnungsweite der Verbindungsöffnung größer als die seitlichen Abmessungen des Verbindungsabschnitts des metallischen Kontaktpartners dimensioniert ist, kann dieser problemlos an die freiliegende Leiterbahn herangeführt werden. Die Leiterbahn bleibt plan, d.h. eine Umformung derselben ist nicht erforderlich. Der für die nachfolgende Laserschweißung/-lötung erforderliche enge Anlage- oder Berührungskontakt zwischen der Leiterbahn und dem Verbindungsabschnitt des metallischen Kontaktpartners kann deshalb sicher gewährleistet werden.

Im Falle einer Verschweißung schmilzt die Leiterbahn in einem zentralen Bereich rasch auf, wodurch gewährleistet wird, daß ausreichend Material für den Aufbau einer stabilen Schweißverbindung zur Verfügung steht. Aufgrund des guten thermischen Kontaktes zwischen dem aufgeschmolzenen Leiterbahnmaterial und dem darunterliegenden Verbindungsabschnitt des Kontaktpartners kommt es auch zu einem Aufschmelzen des letzteren.

Bei einer Lötverbindung ist in an sich bekannter Weise zusätzlich ein Lotmaterial zwischen der Leiterbahn und dem Verbindungsabschnitt vorzusehen. Das Lotmaterial kann beispielsweise als stirnseitige Lotschicht auf dem Verbindungsabschnitt oder an der Leiterbahn abgelagert sein.

Eine bevorzugte Ausführungsvariante des erfindungsgemäßen Verfahrens kennzeichnet sich dadurch, daß zwischen der Verbindungsöffnung und der Beleuchtungsöffnung ein die Leiterbahn durchsetzendes Durchtrittsloch mit kleineren seitlichen Abmessungen als die Öffnungsweite der Verbindungsöffnung ausgebildet wird und daß ein an dem Verbindungsabschnitt des Kontaktpartners vorgesehener Vorsprung durch das Durchtrittsloch hindurchgeführt wird. Beim Schweißvorgang strahlt das Laserlicht direkt auf den Vorsprung, der daraufhin aufschmilzt, auf die Leiterbahn fließt und mit dieser unter Aufschmelzen der Leiterbahn die Schweißverbindung realisiert. Der Vorsprung stellt somit einen "Schweißmaterialvorrat" für die zu schaffende Verbindung dar.

Bei einem Lötvorgang kann das Lotmaterial auf dem Vorsprung oder an der Leiterbahn abgelagert sein.

Es hat sich gezeigt, daß auf der vom Laserlicht bestrahlten Seite der Leiterbahn keine zusätzliche Absorptionsschicht benötigt wird, um ausreichend Energie für das Aufschmelzen der Leiterbahn beim Schweißprozeß einzukoppeln.

Es kann vorteilhaft sein, bei der Herstellung der flexiblen Leiterplatte eine die Leiterbahn innerhalb der Beleuchtungsöffnung abdeckende organische Korrosionsschutzschicht auf die Leiterbahn aufzubringen. Durch diese wird eine unerwünschte Oberflächenoxidierung der Leiterbahn im Öffnungsbereich vermieden.

Vorzugsweise weist die Leiterbahn eine Dicke zwischen 40 bis 150 um, insbesondere zwischen 50 bis 70 µm auf. Es hat sich gezeigt, daß sich in diesem Dickenbereich weitgehend problemlos hochqualitative Schweißverbindungen erzielen lassen.

Mit besonderem Vorteil wird das erfindungsgemäße Verfahren zur Direktkontaktierung von Kontaktstiften oder von Anschlußstiften eines elektrischen Bauteils an die flexible Leiterplatte eingesetzt.

In diesem Zusammenhang besteht eine wichtige technische Anwendung der erfindungsgemäßen elektrischen Verbindungsstelle in der Kontaktierung von Elektrobauteilen, die gemeinsam mit einem Steuergerät in einem Motor oder Getriebe eines Kfz untergebracht sind. Für solche sogenannten mechatronischen Steuerungssysteme wurde kürzlich ein technisches Konzept entwickelt, bei dem eine in dem Steuergerätgehäuse untergebrachte elektronische Schaltung über eine durch einen Dichtspalt des Gehäuses nach außen geführte flexible Leiterplatte mit den Elektrobauteilen in elektrischer Verbindung steht. Einzelheiten des Aufbaus hinsichtlich der Verbindung zwischen der elektronischen Schaltung und der flexiblen Leiterplatte und der Gehäusedurchführung sind in der WO 98/44593 beschrieben. Für diese Technologie schafft die erfindungsgemäße elektrische Verbindungsstelle nun eine geeignete (und kostengünstige) Möglichkeit, die im Getriebe (Motor) vorhandenen Elektrobauteile (Sensoren, Aktoren, usw.) ebenfalls direkt - d.h. ohne Bauteilstecker oder ähnliches - mit der flexiblen Leiterplatte zu verbinden, und zwar so, daß die Verbindung den in einem Getriebe (Motor) herrschenden Umgebungsbedingungen (Temperaturbereich von etwa -40°C bis 150°C, Vibrationen bis etwa 40 g) standzuhalten vermag.

Weitere vorteilhafte Ausgestaltungen der Erfindung sind in den Unteransprüchen angegeben.

Die Erfindung wird nachfolgend anhand eines Ausführungsbeispiels und Ausführungsvarianten unter Bezugnahme auf die Zeichnung erläutert; in dieser zeigt:
- Fig. 1a: eine schematische Schnittdarstellung einer flexiblen Leiterplatte mit einem darunter angeordneten metallischen Kontaktpartner vor dem Aufbau der Schweiß- oder Lötverbindung gemäß einem Ausführungsbeispiel der Erfindung;
- Fig. 1b: einen Ausschnitt der in Fig. 1a gezeigten flexiblen Leiterplatte in Draufsicht;
- Fig. 2: eine schematische Schnittdarstellung einer ersten Ausführungsvariante der Erfindung;
- Fig. 3: eine schematische Darstellung einer weiteren Ausführungsvariante der Erfindung in Draufsicht;
- Fig. 4: eine schematische Schnittdarstellung einer mechatronischen Anordnung bestehend aus Getriebesteuergerät, flexibler Leiterplatte und direkt angebundenem Elektrobauteil; und
- Fig. 5a,b: Perspektivansichten der Verbindung zwischen flexibler Leiterplatte und Elektrobauteil von seitlich oberhalb bzw. seitlich unterhalb der Leiterplatte.

Nach Fig. 1a umfaßt eine flexible Leiterplatte 1 eine erste Isolationsschicht 2 und eine zweite Isolationsschicht 3, zwischen denen eine Leiterbahn 4 eingebettet ist.

Die Leiterbahn 4 kann beispielsweise aus Cu bestehen und eine Dicke im Bereich von etwa 40 µm bis 150 µm aufweisen. Die Isolationsschichten 2, 3 können aus einem Polyimid- oder Polyestermaterial gebildet sein und jeweils eine Dicke von etwa 25 oder auch 50 um aufweisen. Zwischen der Leiterbahn 4 und den Isolationsschichten 2, 3 kann ferner in nicht dargestellter Weise ein Acryl- oder Epoxidharzkleber vorhanden sein.

In der ersten Isolationsschicht 2 ist eine Beleuchtungsöffnung 5 ausgebildet. Der Beleuchtungsöffnung 5 gegenüberliegend weist die zweite Isolationsschicht 3 eine Verbindungsöffnung 6 auf. Beide Öffnungen 5, 6 können kreisscheibenförmig sein.

Die Öffnungen 5, 6 werden vorzugsweise vor der Herstellung der Leiterplatte 1 in die noch getrennten Isolationsschichten 2, 3 eingebracht. Nach dem Zusammenfügen der Isolationsschichten 2, 3 kann im Bereich der Beleuchtungsöffnung 5 und ggf. auch der Verbindungsöffnung 6 eine dünne Korrosionsschutzschicht 7 auf der Leiterbahn 4 abgelagert werden.

Unterhalb der Leiterbahn 4 befindet sich ein mit der Leiterbahn 4 zu verschweißender, zylinderförmiger, metallischer Kontaktpartner 8. Der Kontaktpartner 8 ist ein Kontaktstift eines Steckverbinders und kann aus einer Cu-Legierung, beispielsweise CuSn4/5/6, CuSn5Pb1, CuSn4Pb1, CuTeT oder Cu-NilPblT bestehen.

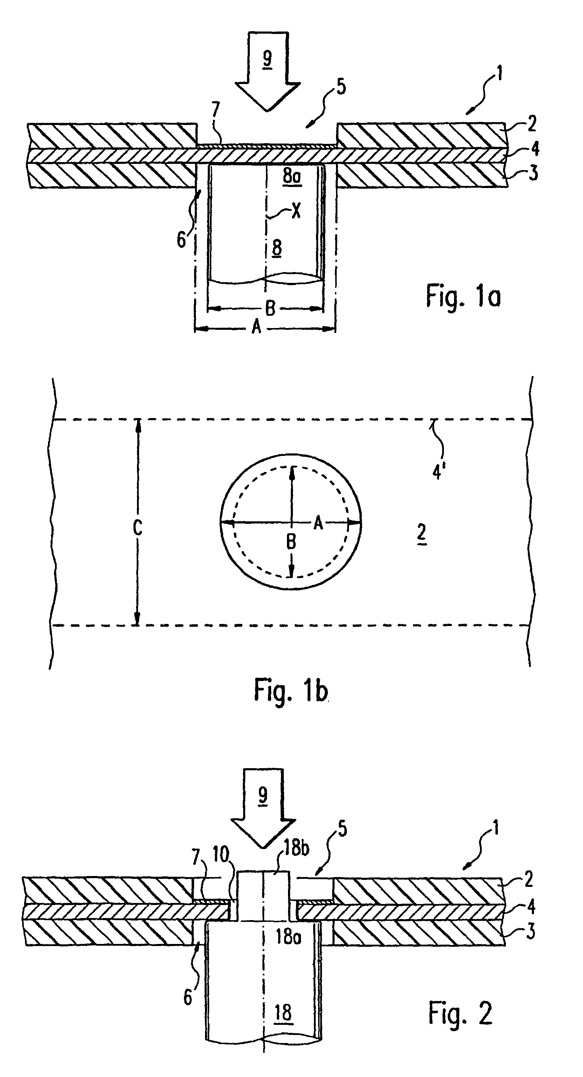

Nachfolgend wird anhand der Fig. 1a und 1b eine erste Ausführungsmöglichkeit des erfindungsgemäßen Verfahrens für den Fall der Herstellung einer Schweißverbindung beschrieben.

Anfänglich sind die flexible Leiterplatte 1 und der Kontaktpartner 8 voneinander räumlich getrennt. Dann werden die Leiterplatte 1 und der Kontaktpartner 8 in seitlicher Richtung so zueinander ausgerichtet, daß die Zentralachse X des Kontaktpartners 8 im wesentlichen mittig die Verbindungsöffnung 6 durchläuft. Nachfolgend werden der Kontaktpartner 8 und die Leiterplatte 1 einander in der Weise angenähert, daß ein stirnseitiger Abschnitt 8a des Kontaktpartners 8 durch die Verbindungsöffnung 6 hindurchtritt und an der Leiterbahn 4 zur Anlage kommt. Damit dies möglich ist, weist der stirnseitige Abschnitt 8a des Kontaktpartners 8 einen Durchmesser B (beispielsweise 2 mm) auf, der kleiner als der Öffnungsdurchmesser A der Verbindungsöffnung 6 (beispielsweise 3 mm) ist.

Der Annäherungsschritt kann sowohl bei fixierter Leiterplatte 1 und bewegtem Kontaktpartner 8 als auch bei fixiertem Kontaktpartner 8 und bewegter Leiterplatte 1 durchgeführt werden.

Figur 1b zeigt die Lage der Leiterplatte 1 und des Kontaktpartners 8 in Draufsicht. Die Konturlinie 4' veranschaulicht die Breite C der Leiterbahn 4. Die Breite C der Leiterbahn 4 kann sich in nicht dargestellter Weise im Bereich der Öffnungen 5, 6 erweitern und im Bereich außerhalb der Öffnungen ggf. kleiner als A oder sogar B sein.

In einem nächsten Schritt wird mittels eines Lasers Laserlicht 9 durch die Beleuchtungsöffnung 5 hindurch auf die Korrosionsschutzschicht 7 oder, falls eine solche nicht vorhanden ist, direkt auf die Leiterbahn 4 geschickt.

Die Korrosionsschutzschicht (beispielsweise Carbonschicht) verdampft bei etwa 60°C, d.h. am Beginn der Laseranwendung noch bevor es zu einem Aufschmelzen der Leiterbahn 4 kommt. Dies gewährleistet, daß das Material der Korrosionsschutzschicht 7 das Schweißgefüge nicht in die Gefügefestigkeit beeinträchtigendem Maße verunreinigen kann.

Das Laserlicht 9 schmilzt nun zunächst die Leiterbahn 4 und nachfolgend die Oberfläche des Abschnitts 8a auf. Die Laserparameter (Pulsenergie, Wiederholungsrate, usw.) sind dabei so einzustellen, daß einerseits ausreichend aufgeschmolzenes Schweißmaterial erzeugt wird, andererseits jedoch ein vollständiges Wegschmelzen der Leiterbahn 4 oder eine Beschädigung der Leiterplatte 1 vermieden wird.

Gute Schweißresultate werden mit einem gepulsten Nd:YAG-Laser erzielt.

Nachdem eine ausreichende Menge von aufgeschmolzenem Schweißmaterial erzeugt wurde, wird der Laser abgeschaltet, so daß durch Abkühlung und Verfestigung der Schmelze die Schweißverbindung entsteht.

Die in Fig. 2 gezeigte Variante der Erfindung unterscheidet sich von dem in den Fig. 1a, 1b gezeigten Ausführungsbeispiel im wesentlichen lediglich durch eine konstruktiv unterschiedliche Ausbildung des Kontaktpartners 18 sowie ein Durchtrittsloch 10, das in einem zentralen Bereich der Verbindungsöffnung 6 durch die Leiterbahn 4 hindurchläuft.

Der Kontaktpartner 18 ist an seinem stirnseitigen Abschnitt 18a mit einem Vorsprung 18b ausgestattet, welcher nach dem zuvor beschriebenen Annäherungsschritt durch das Durchtrittsloch 10 hindurchragt. Dies hat zur Folge, daß bei dem nachfolgenden Laserschweißschritt zunächst der Vorsprung 18b des Kontaktpartners 18 aufgeschmolzen wird. Durch eine ausreichend große Dimensionierung des Vorsprungs 18b kann gewährleistet werden, daß beim Schweißschritt genügend Schweißmaterial zur Verfügung steht.

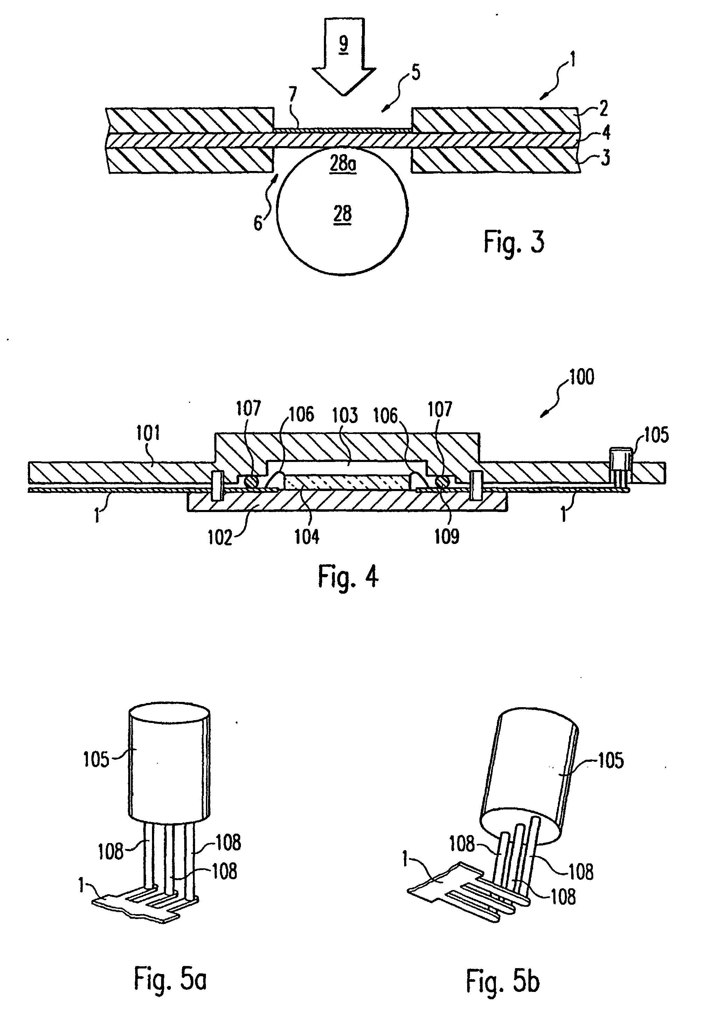

Fig. 3 zeigt in Draufsicht eine weitere Ausführungsvariante der Erfindung. Der Kontaktpartner 28 ist ebenfalls zylindrisch, die Leiterbahn 4 liegt hier jedoch - anders als in den Fig. 1a, 1b und 2 - an der Umfangswand des Kontaktpartners 28 an. Der in die Verbindungsöffnung 6 vorstehende Abschnitt 28a des Kontaktpartners 28 wird hier also durch die Wandkrümmung des Kontaktpartners 28 realisiert. Bei dieser Ausführungsvariante ist eine Mehrpunktschweißung entlang der Berührungslinie Leiterbahn 4/Kontaktpartner 28 realisierbar.

Gemäß Fig. 4 kann die Erfindung mit besonderem Vorteil in einem Getriebe oder einem Motor zur Kontaktierung von elektrischen Bauteilen (Aktoren, Sensoren) über eine flexible Leiterplatte eingesetzt werden. Fig. 4 zeigt in beispielhafter Weise ein Getriebesteuergerät 100. Das Getriebesteuergerät 100 umfaßt einen Gehäusedeckel 101 und eine metallische Bodenplatte 102. Der Gehäusedeckel 101 und die Bodenplatte 102 umschließen einen Hohlraum 103. In dem Hohlraum 103 befindet sich ein Schaltungsträger 104, auf dem eine elektronische Schaltung realisiert ist. Als Schaltungsträger 104 kann ein Keramiksubstrat vorgesehen sein, das mit einem elektrisch isolierenden Wärmeleitkleber auf die als Wärmesenke dienende metallische Bodenplatte 102 aufgeklebt ist.

Der Schaltungsträger 104 ist allseitig von einer flexiblen Leiterplatte 1 umgeben, die entsprechend der bisherigen Beschreibung hergestellt und ausgeführt ist. Die Leiterbahnen 4 der flexiblen Leiterplatte 1 sind über Bonddrähte 106 oder über direkte elektrische Kontaktklebungen (nicht dargestellt) mit entsprechenden Kontaktpads auf dem Schaltungsträger 104 verbunden.

Der Gehäusedeckel 101 weist eine umlaufende, stufenförmige Dichtfläche 107 auf, an die eine Ringdichtung 109 anliegt. Die flexible Leiterplatte 1 ist zwischen der Ringdichtung 109 und der metallischen Bodenplatte 102 aus dem Hohlraum 103 des Steuergerätgehäuses 101, 102 herausgeführt.

Der Gehäusedeckel 101 ist als Tragkörper des Steuergeräts 100 ausgeführt und bildet darüber hinaus eine Montageplatte für außerhalb des Hohlraums 103 angeordnete Elektrobauteile. Als Beispiel für ein Elektrobauteil ist in Fig. 4 ein Temperatursensor 105 dargestellt, der in einer Montageöffnung des Gehäusedeckels 101 befestigt ist.

Die flexible Leiterplatte 1 ist an der Unterseite des Gehäusedeckels 101 zu dem Temperatursensor 105 hingeführt und kontaktiert dort Anschlußstifte 108 des Temperatursensors 105. Die Anschlußstifte 108 realisieren die Kontaktpartner.

Die Fig. 5a und 5b zeigen in perspektivischen Ansichten die Verbindung zwischen der flexiblen Leiterplatte 1 und den Anschlußstiften 108. Es wird deutlich, daß die flexible Leiterplatte 1 mit umfangsseitig hervorstehenden Fingern zur Kontaktierung der Anschlußstifte 108 ausgeführt sein kann.

Zusammenfassend ist festzustellen, daß bei der in den Fig. 4, 5a und 5b gezeigten mechatronischen Anordnung sowohl im Bereich der Verbindung Steuergerät-Leiterplatte als auch - aufgrund der erfindungsgemäßen Direktverbindung zwischen den Anschlußstiften 108 und der Leiterbahnen 4 - im Bereich der Verbindung Leiterplatte-Elektrobauteil zusätzliche Teile wie Stecker u. dergleichen eingespart werden, wodurch besonders bei einer Herstellung in Großserie deutliche Kosteneinsparungen ermöglicht werden.

## Patentansprüche

1. Verfahren zur Herstellung einer elektrischen Verbindung zwischen einer flexiblen Leiterplatte (1), welche aus zwei Isolationsschichten (2, 3) und wenigstens einer dazwischen verlaufenden metallischen Leiterbahn (4) aufgebaut ist, und einem metallischen Kontaktpartner (8, 18, 28, 108), bei dem:
- in der ersten Isolationsschicht (2) eine Beleuchtungsöffnung (5) ausgebildet wird;
- in der zweiten Isolationsschicht (3) gegenüberliegend der Beleuchtungsöffnung (5) eine Verbindungsöffnung (6) ausgebildet wird;
- ein in bezug auf seine seitlichen Abmessungen kleiner als die Öffnungsweite (A) der Verbindungsöffnung (6) dimensionierter Verbindungsabschnitt (8a, 18a, 28a) des metallischen Kontaktpartners (8, 18, 28, 108) durch die Verbindungsöffnung (6) hindurch in Anlage zu der metallischen Leiterbahn (4) gebracht wird; und
- mittels durch die Beleuchtungsöffnung (5) gerichteten Laserlichts (9) eine Strahlungserwärmung der Leiterbahn (4) und des an dieser anliegenden Verbindungsabschnittes (8a, 18a, 28a) und dabei die Ausbildung einer Schweiß- oder Lötverbindung herbeigeführt wird.

2. Verfahren nach Anspruch 1,
**dadurch gekennzeichnet,**
- **daß** zwischen der Verbindungsöffnung (6) und der Beleuchtungsöffnung (5) ein die Leiterbahn (4) durchsetzendes Durchtrittsloch (10) mit kleineren seitlichen Abmessungen als die Öffnungsweite (A) der Verbindungsöffnung (6) ausgebildet wird, und
- **daß** ein an dem Verbindungsabschnitt (8a, 18a, 28a) des Kontaktpartners vorgesehener Vorsprung (18b) durch das Durchtrittsloch (10) hindurchgeführt wird.

3. Verfahren nach einem der Ansprüche 1 oder 2,
**dadurch gekennzeichnet,**
**daß** die flexible Leiterplatte (1) eine Dicke zwischen 40 - 150 µm, insbesondere zwischen 50 - 70 µm aufweist.

4. Verfahren nach einem der vorhergehenden Ansprüche,
**dadurch gekennzeichnet,**
**daß** der metallische Kontaktpartner (8, 18, 28, 108) ein Anschlußstift eines elektrischen Bauteils (105) ist und der Verbindungsabschnitt (8a, 18a) durch die freie Stirnfläche des Anschlußstiftes (108) realisiert ist.

5. Verfahren nach einem der Ansprüche 1 bis 3,
**dadurch gekennzeichnet,**
**daß** der metallische Kontaktpartner (8, 18, 28, 108) ein Anschlußstift eines elektrischen Bauteils (105) ist und der Verbindungsabschnitt (28a) durch eine Umfangswandfläche des Anschlußstiftes (108) realisiert ist.

6. Verfahren nach einem der vorhergehenden Ansprüche,
**dadurch gekennzeichnet,**
**daß** auf die Leiterbahn (4) eine die Beleuchtungsöffnung (5) abdeckende organischen Korrosionsschutzschicht (7) aufgebracht wird.

7. Elektrische Verbindungsstelle zwischen einer flexiblen Leiterplatte (1) und einem metallischen Kontaktpartner (8, 18, 28, 108), bei der
- die flexible Leiterplatte (1) aus zwei Isolationsschichten (2, 3) und wenigstens einer dazwischen verlaufenden metallischen Leiterbahn (4) aufgebaut ist,
- in der ersten Isolationsschicht (2) eine Beleuchtungsöffnung (5) ausgebildet ist,
- in der zweiten Isolationsschicht (3) gegenüberliegend der Beleuchtungsöffnung (5) eine Verbindungsöffnung (6) ausgebildet ist,
- der metallische Kontaktpartner (8, 18, 28, 108) einen in bezug auf seine seitlichen Abmessungen kleiner als die Öffnungsweite (A) der Verbindungsöffnung dimensionierten Verbindungsabschnitt (8a, 18a, 28a) umfaßt,
- der Verbindungsabschnitt (8a, 18a, 28a) durch die Verbindungsöffnung (6) hindurchragt und mit der metallischen Leiterbahn (4) unter Verwendung eines beim Verbindungsvorgang durch die Beleuchtungsöffnung (5) Strahlungswärme einkoppelnden Lasers verschweißt oder verlötet ist.

8. Elektrische Verbindungs stelle nach dem vorhergehenden Anspruch, **dadurch gekennzeichnet, daß** der Kontaktpartner(8, 18, 28, 108) ein Anschlußstift oder ein Kontaktstift ist.

9. Anordnung zum vollständigen Einbau in einen Motor oder ein Getriebe eines Kraftfahrzeugs,
- mit einem Steuergerät (100), das ein öldichtes Gehäuse (101, 102) aufweist, in dem eine elektronische Schaltung untergebracht ist,
- mit einer flexiblen Leiterplatte (1), die mit der elektronischen Schaltung in elektrischer Verbindung steht und durch einen Dichtspalt des Gehäuses (101, 102) nach außen geführt ist, und
- mit außerhalb des Steuergerätes (100) angeordneten Elektrobauteilen (105), insbesondere Sensoren und Aktoren, deren Anschlußstifte (108) direkt über eine elektrische Verbindungsstelle nach Anspruch 7 mit der flexiblen Leiterplatte (1) verbunden sind.

## Claims

1. Method for producing an electrical connection between a flexible printed circuit board (1), which is constructed from two insulating layers (2, 3) and at least one metallic conductor track (4) situated between them, and a metallic contact partner (8, 18, 28, 108), whereby:
- an illumination opening (5) is formed in the first insulating layer (2),
- a connection opening (6) is formed in the second insulating layer (3) opposite the illumination opening (5),
- a connection section (8a, 18a, 28a) of the metallic contact partner (8, 18, 28, 108) which is dimensioned in respect of its lateral dimensions to be smaller than the opening width (A) of the connection opening (6) is brought through the connection opening (6) to be adjacent to the metallic conductor track (4), and
- laser light (9) directed through the illumination opening (5) is used to produce a radiation heating effect on the conductor track (4) and on the connection section (8a, 18a, 28a) lying against the latter, and thereby to form a welded or soldered connection.

2. Method according to Claim 1, **characterised in that**
- an access hole (10) passing through the conductor track (4) and having smaller lateral dimensions than the opening width (A) of the connection opening (6) is formed between the connection opening (6) and the illumination opening (5), and
- a projection (18b) provided on the connection section (8a, 18a, 28a) of the contact partner is introduced through the access hole (10).

3. Method according to one of Claims 1 or 2, **characterised in that** the flexible printed circuit board (1) exhibits a thickness in the range 40 to 150 µm, in particular in the range 50 to 70 µm.

4. Method according to one of the preceding claims, **characterised in that** the metallic contact partner (8, 18, 28, 108) is a terminal post of an electrical component (105) and that the connection section (8a, 18a) is formed by the free end face of the terminal post (108).

5. Method according to one of Claims 1 to 3, **characterised in that** the metallic contact partner (8, 18, 28, 108) is a terminal post of an electrical component (105) and that the connection section (28a) is formed by a circumferential wall surface of the terminal post (108).

6. Method according to one of the preceding claims, **characterised in that** an organic anti-corrosion layer (7) covering the illumination opening (5) is applied to the conductor track (4).

7. Electrical connection point between a flexible printed circuit board (1) and a metallic contact partner (8, 18, 28, 108), whereby
- the flexible printed circuit board (1) is constructed from two insulating layers (2, 3) and at least one metallic conductor track (4) situated between them,
- an illumination opening (5) is formed in the first insulating layer (2),
- a connection opening (6) is formed in the second insulating layer (3) opposite the illumination opening (5),
- the metallic contact partner (8, 18, 28, 108) includes a connection section (8a, 18a, 28a) which is dimensioned in respect of its lateral dimensions to be smaller than the opening width (A) of the connection opening,
- the connection section (8a, 18a, 28a) projects through the connection opening (6) and is welded or soldered to the metallic conductor track (4) using the radiated heat produced by a laser directed through the illumination hole (5) during the connection operation.

8. Electrical connection point according to one of the preceding claims, **characterised in that** the contact partner (8, 18, 28, 108) is a terminal post or a contact pin.

9. Arrangement for complete incorporation into an engine or a gearbox of a motor vehicle
- with a control unit (100) having an oil-tight housing (101, 102) in which an electronic circuit is accommodated,
- with a flexible printed circuit board (1) which is connected electrically to the electronic circuit and taken to the outside through a packed sealing gap in the housing (101, 102), and
- with electrical components (105) located outside the control unit (100), in particular actuators and sensors, whose terminal posts (108) are connected directly by way of an electrical connection point according to Claim 7 to the flexible printed circuit board (1).

## Revendications

1. Procédé de production d'une connexion électrique entre un circuit imprimé flexible (1), qui est composé de deux couches d'isolant (2, 3) et d'au moins une piste conductrice métallique (4) qui s'étend entre celles-ci, et un partenaire de contact métallique (8, 18, 28, 108), dans lequel :
- on forme une ouverture d'éclairage (5) dans la première couche d'isolant (2) ;
- on forme en face de l'ouverture d'éclairage (5) une ouverture de connexion (6) dans la deuxième couche d'isolant (3);
- on met un segment de connexion (8a, 18a, 28a) du partenaire de contact métallique (8, 18, 28, 108) qui est dimensionné plus petit en ce qui concerne ses dimensions latérales, que la largeur d'ouverture (A) de l'ouverture de connexion (6), en contact avec la piste conductrice métallique (4) à travers l'ouverture de connexion (6) ; et
- au moyen d'une lumière laser (9) projetée à travers l'ouverture d'éclairage (5), on produit un échauffement par rayonnement de la piste conductrice (4) et du segment de connexion (8a, 18a, 28a) appuyé contre celle-ci et, par cette action, la formation d'une connexion par soudage ou brasage.

2. Procédé selon la revendication 1,
**caractérisé en ce que**
- on forme, entre l'ouverture de connexion (6) et l'ouverture d'éclairage (5), un trou débouchant (10) qui traverse la piste conductrice (4) et qui possède des dimensions latérales plus petites que la largeur d'ouverture (A) de l'ouverture de connexion (6), et
- on enfile une saillie (18b) prévue sur le segment de connexion (8a, 18a, 28a) du partenaire de contact à travers le trou débouchant (10).

3. Procédé selon une des revendications 1 ou 2,
**caractérisé en ce que**
le circuit imprimé flexible (1) présente une épaisseur d'entre 40-150 µm, en particulier d'entre 50-70 µm.

4. Procédé selon une des revendications précédentes,
**caractérisé en ce que**
le partenaire de contact métallique (8, 18, 28, 108) est une broche de connexion d'un composant électrique (105) et le segment de liaison (8a, 18a) est réalisé par la surface frontale libre de la broche de connexion (108).

5. Procédé selon une des revendications 1 à 3,
**caractérisé en ce que**
le partenaire de contact métallique (8, 18, 28, 108) est une broche de connexion d'un composant électrique (105) et le segment de connexion (28a) est constitué par une surface de paroi périphérique de la broche de connexion (108).

6. Procédé selon une des revendications précédentes,
**caractérisé en ce que**,
sur la piste conductrice (4), est déposée une couche de protection anticorrosive organique (7) qui recouvre l'ouverture d'éclairage (5).

7. Jonction électrique entre un circuit imprimé flexible (1) et un partenaire de contact métallique (8, 18, 28, 108), dans laquelle
- le circuit imprimé flexible (1) est composé de deux couches d'isolant (2, 3) et d'au moins une piste conductrice métallique (4) s'étendant entre celles-ci,
- une ouverture d'éclairage (5) est formée dans la première couche d'isolant (2),
- une ouverture de connexion (6) est formée dans la deuxième couche d'isolant (3), en face de l'ouverture d'éclairage (5),
- le partenaire de contact métallique (8, 18, 28, 108) comprend un segment de connexion (8a, 18a, 28a) dimensionné plus petit, dans ses dimensions latérales, que la largeur d'ouverture (A) de l'ouverture de connexion,
- le segment de connexion (8a, 18a, 28a) fait saillie à travers l'ouverture de connexion (6) et est soudé à la piste conductrice métallique (4) à l'aide d'un laser qui introduit une chaleur de rayonnement à travers l'ouverture d'éclairage (5) lors de l'opération de connexion par soudage ou brasage.

8. Jonction électrique selon la revendication précédente,
**caractérisé en ce que**
le partenaire de contact métallique (8, 18, 28, 108) est une broche de connexion ou une broche de contact.

9. Dispositif destiné à être entièrement incorporé dans un moteur ou dans une boîte de vitesses d'un véhicule automobile, comprenant :
- un appareil de commande (100) qui présente un boîtier étanche à l'huile (101, 102) dans lequel est logé un circuit électronique,
- un circuit imprimé flexible (1) qui est en liaison électrique avec le circuit électronique et s'étend à l'extérieur à travers une fente d'étanchéité du boîtier (101, 102), et
- des composants électriques (105), en particulier des capteurs et des acteurs, disposés à l'extérieur de l'appareil de commande (100) dont les broches de raccordement (108) sont reliées directement au circuit imprimé flexible (1) au moyen d'une jonction électrique selon la revendication 7.
